(19) Europäisches Patentamt
European Patent Office
Office européen des brevets

(11) **EP 4 421 598 A1**

(12) **EUROPEAN PATENT APPLICATION**

(43) Date of publication:
**28.08.2024 Bulletin 2024/35**

(21) Application number: **23382177.6**

(22) Date of filing: **27.02.2023**

(51) International Patent Classification (IPC):
**G06F 3/041** (2006.01)   **G06F 3/044** (2006.01)
**H03K 17/96** (2006.01)

(52) Cooperative Patent Classification (CPC):
**G06F 3/0445; G06F 3/041; H03K 17/96;
H03K 17/9618;** H03K 2017/9602;
H03K 2217/94042

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Consejo Superior De Investigaciones
Científicas**
**41013 Sevilla (ES)**

(72) Inventors:
 • **Ghaffarinejad, Ali**
  **41092 Sevilla (ES)**

 • **Barranco Quero, Angel**
  **41092 Sevilla (ES)**
 • **García Casas, Xabier**
  **41092 Sevilla (ES)**
 • **Borrás Martos, Ana Isabel**
  **41092 Sevilla (ES)**
 • **Sánchez Valencia, Juan Ramón**
  **41092 Sevilla (ES)**

(74) Representative: **Pons**
**Glorieta Rubén Darío 4**
**28010 Madrid (ES)**

(54) **SELF-POWERED TRIBOELECTRIC TOUCH CONTACT TRANSDUCTOR DEVICE**

(57) A triboelectric device that acts as self-powered transductor in a reduced scale to obtain physicochemical information instantaneously. The device comprises one or more transductors (1) comprising a bottom electrode (2), a charged triboelectric friction element (3) placed over the bottom electrode (2), and at least one top electrode (4) smaller than the bottom electrode (2) and placed over the triboelectric friction element (3) and defining at least one gap (5) on the friction element (3) of nonoverlapping area with respect to the bottom electrode (2), exposing the triboelectric friction element (3) to the external environment so that contacting with a finger or solid varies instantaneously the capacitance of the transductor (1) generating an electrical signal containing physicochemical information of the solid in contact with the device readout by an acquisition and analysis module (7) which comprises at least of a resistive load.

FIG. 1.

EP 4 421 598 A1

**Description**

**OBJECT OF THE INVENTION**

The invention is in the field of touch contact sensors for the application to determine the tactile interaction between a human and an electronic device or screen with an instantaneous response. The sensor works in a self-powered mode as the contact with the finger generates the electrical sensing signal through triboelectrification and capacitance variance. The electrical charging of the triboelectric surface and the transductor architecture allows for instantaneous (from microseconds to a few milliseconds) responses to the human finger or contact with a solid object. The sensor distinguishes between contact with human skin, wet human skin, and different materials, frequency of the contact, and direction of finger movement. When the triboelectric transductors are forming an array, they can be used to provide the location of the contact, physicochemical parameters of the contact event, finger touch recognition and anticounterfeiting purposes.

An object of the present invention is a self-powered transductor device having a new triboelectric configuration for obtaining chemical and physical information from human-device interaction through the sense of touch. The size of the invention is adaptable to the contact area but is preferable in a reduced scale and combinable in the form of an array including a plurality of transductors to achieve multidetection.

**BACKGROUND ART**

The field of harvesting ambient environmental energy has gained great interest in the last decade as a response to the ever-increasing demand to find environmentally friendly alternatives to the global dependence on fossil fuels. One of the applications of the field of energy harvesting is to provide electric power for low-power electronic and wireless devices to reduce their dependency on (rechargeable) batteries. The main motive for the design and fabrication of energy harvesting devices is to develop a system capable of converting ambient and free energy from the surrounding environment of the targeted electronic device. The generated energy can directly power up the target device or it can be stored in an energy storage unit for later use.

One of the great advantages of the development of micro energy harvesters is their implementation within self-powered sensors. Thus, sensor technology can widely profit from the implementation of self-powered approaches as the dependency on batteries and grid powering limits their size, wireless application, portability, working lifetime, recyclability, and environmental and implantable compatibility. Two main approaches can be found regarding the combination of energy harvesters and self-powered sensors, either the energy harvester system works as an external power supply for the sensor or the electrical signal (voltage, current, peak power, etc.) generated by the energy harvesting system is utilized as sensing signal to the defined analytes. It is this second approach which poses major advantages regarding the miniaturization of devices and higher portability.

Concretely, tactile or touch sensing is a topic of important interest as their potential integration enhances the applications of machine-human interaction interfaces. Thus, these sensors can be applied as transducer systems on the interaction with a computer, smart devices, touch screens, smart textiles, power switches, key controls, robotics, industrial automatization, etc. A touch sensor can be used in several of these applications instead of a mouse. Traditionally, the transducing mechanisms that have been employed for touch sensors include piezoelectric, resistive, and capacitive effects, which rely on the physical deformation of the sensor upon interaction with the human touch. Recently, a different mechanism has arisen based on the triboelectric effect, i.e. the spontaneous charging of two different surfaces after contact with each other. Importantly, such a mechanism has fostered the development of self-powered triboelectric sensors in which the generated current or voltage has been used to detect contact with human skin or different materials, force, impact, pressure, contact time, touch frequency, and other physicochemical parameters of the contact event.

In document US9921678B2 a triboelectric layer is sandwiched between two electrodes and on top of the top electrode a material that becomes electrically charged after being contacted with the finger is emplaced. This device generates a voltage peak upon contact with a finger or different solid materials. An array of such devices in the form of a keyboard is claimed for anticounterfeiting and typing recognition.

In document US10042446B2 an insulator surface is emplaced on top of an electrode, the electrode is connected to the readout circuitry which determines the position of an object (finger) when it comes into contact with the insulator surface producing a local charge displacement. The separation movement generates a reversed charge displacement.

Document US2021/0404844A1 presents a variation of such an approach in which the electrode is displayed as a grid disposed in or on the substrate. The different grid shapes and gaps between the conductor fingers and electrode emplacement allow for high-resolution sensing of the finger movement and location.

In document US 2020/0183511A1 a triboelectric sensor is presented by emplacing a triboelectric layer on top of an electrode, being the electrode in the form of a thin film that might include a high resistance portion and a low resistance counterpart. Such configuration allows for a built-on load resistance which also provides a simplified circuit for the implementation in the form of arrays of triboelectric sensors.

Document WO2019/171295A2 deals with a thin film-based readout circuitry for triboelectric touch sensors where the sensing element is based on a thin film transistor coupled to a triboelectric sensor, wherein the transistor is configured to receive the voltage pulse and output signal generated by the contact force or the contact event.

Document WO2019/155376 develops around the application of a polymer matrix with defined composition acting as a triboelectric layer on top of a single electrode on a substrate with the combination acting as a touch/force responsive sensor. With a similar sensor architecture, EP3783328A1 presents a force sensor comprising a triboelectric nanocomposite layer combining a carbonate copolymer and a fluoro-containing silsesquioxane compound.

Document EP3742143A1 presents a triboelectric impact sensor including a substrate, an electrode and a triboelectric layer on top of the electrode layer with the electrode connected to a diode bridge configured to sense an impact on or vibration of the triboelectric sensor.

Document EP3617856A1 presents a combination of a capacitive sensor and a triboelectric touch/force sensor. In the triboelectric mode, two triboelectric layers are separated vertically by a gap. Each triboelectric layer of different electro affinity is in contact with an electrode, forming the sandwich electrode 1 / thin film 1/ gap / thin film 2 / electrode 2. When the user presses the top electrode, the thin film 1 makes contact with thin film 2 and the contact-separation event produces a detectible electrical signal across the electrodes that can be measured by an appropriate circuitry coupled to the electrodes.

The aforementioned proposals have greatly enhanced the potential for the integration of self-powered touch sensors as human-machine interfaces. However, there is yet an urgent need to produce sensible sensors for low-force inputs, and reliable sensors able to distinguish skin contact from different fabrics or polymers. A concrete technical need is to find a triboelectric architecture for touch detection in a very fast and reliable way (below the millisecond threshold) allowing multidetection performance and miniaturization. Also, such a triboelectric architecture needs to solve the reproducible and sensible detection of the finger movement velocity, direction and position.

## DESCRIPTION OF THE INVENTION

The invention is a self-powered triboelectric transductor device that takes advantage of the duality of an energy harvester and a physicochemical transductor based on a triboelectric and variable capacitance effect.

The invention converts the movement of a finger or a solid on or in the proximity of the surface of a friction or triboelectric layer, foil, coating, bulk or plate, hereafter referred to as friction or triboelectric or friction triboelectric element, into an electrical signal by using the triboelectric effect. The shape, duration and amplitude of the generated voltage or current peak and the average power value, as well as these magnitudes recorded under different resistive loads, or other impedance or circuit elements, produced upon the interaction between the finger or solid with the invention, can be used as transduction signals for the detection of the characteristics of the touch properties, such as finger movement velocity, the direction of the movement, touch with a bare finger or wet finger, or a gloved finger or other physicochemical parameters of the contact of the invention with a solid element.

The triboelectric transductor device produces the voltage upon contact electrification and variable capacitance effects in response to the contact with the finger or the solid without reliance on an external power supply, working in a self-powered mode. Thus, the invention presents the duality of being at the same time the transductor and the power generator required to produce the sensing signal.

The objective of the invention is to produce an electrical signal from the movement of a finger or a solid on a triboelectric surface to be used as a sensing signal without the need for an active power source. This means that the transductor device is working in the self-powered mode.

Therefore, in a first step, the invention works as a power source or an energy harvesting device to generate electric energy based on the triboelectrification and instantaneous capacitance variation that occurs when a finger contacts a thin electrode on the surface of a triboelectric friction element, acting as an insulator material in a capacitor, i.e. containing also a bottom small electrode electrically connected to the top electrodes through a resistive load or a readout circuitry. In order to measure the capacitance variation, the invention can comprise a signal acquisition module, connected to the electrodes. In the simplest embodiment, the signal acquisition module comprises a resistive load. In a second step, the device works as a sensor which means the generated signal is representative of a sensed parameter.

In an aspect of the invention, the integration of the triboelectric transductor with a signal processing circuit allows the development of a sensing device to extract physicochemical information and recognize touch patterns. The size of the invention and the charging of the triboelectric element is intended to obtain such information instantaneously (i.e., response time scales ranging from microseconds to a few milliseconds).

To sum up, the invention relates to a self-powered triboelectric touch contact transductor device, said device comprising one or more transductors, and being the device characterized in that each transductor comprises:

- a bottom electrode,

- at least a triboelectric friction element electrically charged, that comprises one or more layers on top of the bottom electrode, being the area of the triboelectric friction element at least as large as the area of the bottom electrode and,
- one or more exposed (i.e. non buried) top electrodes electrically connected and placed on the triboelectric friction element on a surface opposite to the bottom electrode, being the at least one top electrode of a smaller area than the bottom electrode and defining at least one gap on the triboelectric friction element of non-overlapping area with respect to the bottom electrode, exposing the triboelectric friction element to an external environment so that, on contacting with a finger or solid element, the capacitance of the transductor varies and an electrical signal is generated.

The at least one top electrode is smaller than the contacting area of the finger when reaching the triboelectric element, such that the contact area of the finger covers at least the top exposed electrode.

To enhance the time response and the amplitude of the signal, the top electrode can be formed by several interconnected electrodes (as in a bifurcated electrode) leaving exposed the triboelectric layer to be contacted by the finger and the surface of the triboelectric element can be charged by natural or artificial means.

Therefore, the triboelectric or charged friction element is exposed to the external environment so that when a finger makes contact with the top electrode it varies the capacitance of the transductor, which depends on the size of the bottom and top electrodes and the triboelectrification of the triboelectric element, which depends on the previously injected and/or the generated charges upon the contact with the finger or other solid element.

In the simplest readout circuitry or signal acquisition module embodiment, it comprises a resistive load ($R_L$) emplaced between the top and bottom electrodes.

The electrical signal generated by the triboelectric transductor device depends on the rate of the change of effective overlapping area, capacitance and resistive load ($R_L$) between the top and bottom electrodes, charging of the triboelectric element and the physicochemical conditions of the contact event with the triboelectric element and the top electrode.

The device of the invention could further comprise one or more substrates placed under the transductors in contact with the bottom electrode, which could be rigid, flexible or non-flat, among others. The triboelectric transductor of the invention can also work as a self-supported device without the need for a substrate.

Regarding the materials, the electrodes could be manufactured, without excluding other formulations, using thin metal foils, thin metallic films, metal wires, metal nanowires, transparent conducting oxides and polymers, graphene or metal meshes and could be manufactured having a round, triangular or rectangle shape, among others.

Deposition techniques such as physical vapor deposition, chemical vapor deposition, wet chemistry methodologies, lithography and printing can be cited as examples of the available methodologies to produce such films.

The active area of the triboelectric transductor device of the invention is not limited in shape but it is intended to be much smaller than the contact area of the finger. The size of each triboelectric transductor can range preferably from the micrometer to subcentimeter scale to respond to the finger contact instantaneously, preferably, generating a voltage peak in the microsecond to millisecond range, being the duration, amplitude, shape and polarity of the peak some of the signal parameters to distinguish the duration of the contact, relative finger movement, position of the finger, contact velocity, presence of different chemical analytes, etc.

The invention can be multiplied in number in order to cover larger areas.

A defining feature of this invention is that the minimum size of the device is determined by the size of the contact impinging on its surface, for contact areas in the size of micrometer to subcentimeter. Such that it is possible to design a fully functional array of transductors covering a total area similar to that of the contact area of the finger on a given surface.

The triboelectric friction element can be rigid or flexible and must be compatible with the injection or generation of electrical charge on its surface, positively or negatively, with the help of charge injection techniques, or it is charged by natural effects, including repeated contact with the finger. The triboelectric friction element can be dielectric, insulator or semiconductor.

The triboelectric friction element can have a determined functionality as in the case of self-cleanable, omniphobic/philic, anti-bacterial, anti-microbial, anti-fouling and photoactive surfaces.

The triboelectric transductor device of the invention can work as a single self-powered transductor to produce an electric signal from interaction with a finger or can integrate a large number of triboelectric transductors close together forming a regular or irregular distribution and include different triboelectric surfaces or functionalization for sensing from several contacts at the same time or to produce transducing signals to different physicochemical properties at the same time.

The device can also integrate a large number of triboelectric transductors with different electrode sizes, shapes and resistive loads or impedance circuits or other circuit elements to produce different transducing signals from a single contact event, to determine more accurately its physicochemical characteristics. In this latter case, several triboelectric transducers could interact with the same finger to multiply the generated information providing multi-detection and multiplexing (sensing at the same time different chemical and physical factors but also from multiple analytes at the same time, as it can happen in complex touch events or multiple touch events).

For obtaining more transducing signals, a high number of triboelectric transductors could be manufactured using CMOS (complementary metal-oxide semiconductors), MEMS (microelectromechanical systems), IC (Integrated Circuit), PCB (Printed Circuit Boards) technologies and others such as soft-lithography, shadow masking, printing, and laser patterning methods.

An array of transductors functions similarly to a CCD or CMOS image sensor. In this case, each triboelectric transductor can generate a sensing electric signal from the interaction with the incoming finger and be used for example to delimit and measure the interaction zone of the finger.

The invention works as a self-powered transductor by using the generated signal as a source of information from the touch or contact. Thus, the invention produces different electric outputs (voltage or current) in response to different factors of the contacting event. The transductor or transductors can be connected to signal acquisition module to analyse the shape, components, amplitude, duration, and type of electrical signal (voltage and/or current and/or average peak power) generated by the contact with the transductor, particularly the triboelectric element. This information can be used for anticounterfeiting purposes or contact recognition of the finger or typing patterns.

The amplitude, duration, shape, and polarity of such an electrical signal depend on the physicochemical parameters of the contact event. The surface of the triboelectric element also could be chemically functionalized to respond to certain analytes or chemical agents present in the finger. For instance, the triboelectric element can be activated by surface functionalization to produce a specific electric signal when the finger is dried or sweaty or dirty or covered in a certain fabric or when the presence of an analyte related to a certain disease contacts the transductor. Besides, detection could also be based on the comparison of the tactile signal of a finger on two or more sensing elements with triboelectric elements with different functionalizations.

The device of the invention generates the voltage signal from a triboelectric effect by varying the capacitance, $C_{var}$, of the triboelectric element upon interaction with the finger. When the finger makes a contact with the top electrode, the effective overlapping area $A_e$ of the capacitor suddenly increases to $A_e^{Max}$ which makes the total capacitance of the device to increase to $C_{max}$ instantaneously.

Before the finger reaches the top electrodes, the effective overlapping area between the top and bottom electrodes is at minimum value of $A_e^{Min} = L_1 W$ and the capacitance is $C_{min} = \varepsilon_0 \varepsilon_r \frac{A_e^{Min}}{h}$. $L_1$ and W are the dimensions of each top electrode, $\varepsilon_0$ and $\varepsilon_r$ are the vacuum dielectric permittivity and relative permittivity of the triboelectric element correspondingly and h is the thickness of the triboelectric friction element assuming only one layer exists between bottom and top electrodes.

Between the contact and non-contacting states, there is a sudden capacitive variation defined by the ratio $r$ between $C_{max}$ (after the finger contact) and $C_{min}$ (before finger contact).

$$C_{min} = \varepsilon_0 \varepsilon_r \frac{A_e^{Min}}{h} \qquad \text{Eq. 1}$$

$$C_{max} = \varepsilon_0 \varepsilon_r \frac{A_e^{Max}}{h} \qquad \text{Eq. 2}$$

$$r = \frac{C_{max}}{C_{min}} = \frac{A_e^{Max}}{A_e^{Min}} \qquad \text{Eq. 3}$$

The dissipated power in a load ($R_L$) connected to the device can be calculated as:

$$P = k^2 V_{var}^2 \left(\frac{dA_e(t)}{dt}\right)^2 \qquad \text{Eq. 4}$$

wherein $V_{var}$ is a function of charges stored on the surface of the triboelectric element, and k is a constant defined as:

$$k = \left(\frac{\sqrt{R_L}C_0}{S}\right) \qquad \text{Eq. 5}$$

Where $C_0$ is the constant capacitance due to the thickness and S the surface exposed area of the triboelectric element.

The sensed output signal is the voltage across the resistive load indicated by $V_L$. The faster the change of $A_e(t)$ in time, the higher the power delivered to the load $R_L$ and the higher the amplitude of the $V_L$.

The self-powered touch device solutions are of paramount importance in the realization and development of finger-machine interaction, reading as finger not only that of the human condition but including also the robotics environments or the use of prosthetic devices. The key differencing characteristics of the present invention are:

1- A new mechanism for self-powered touch devices based on a sudden capacitance variation and triboelectrification of the touch receiving surface. The capacitance variation occurs as the result of instantaneous contact of the finger with the top exposed electrode, changing its effective area. The physicochemical parameters of the contact interaction with the triboelectric element and the electrode define the shape, amplitude, polarity and duration of the voltage (or current) peak, instantaneous and average power.

2- Self-powered contact sensor relaying on a mechanism not involving mechanical deformation nor relative movement of the transductor components.

3- The friction layer or triboelectric element must be charged either by injecting positive or negative charges on the element using injection techniques (plasma, e-beam, friction, etc) or by natural ways (wind, humidity, finger contact) to ensure an instantaneous signal (below a few milliseconds threshold).

4- There is no need for the finger to slip or move over a certain distance before contacting the top electrode and triboelectric element which helps in reducing the area of the device, preferably, having an active area dimension of micrometer to subcentimeter scale.

5- The condition for the active dimension of the invention in the micrometer to subcentimeter scale, typically much smaller than the contact area of a finger, provides for the instantaneous change of capacitance in the range from microseconds to milliseconds for peak generation (Voltage versus time, i.e. V-t, or current intensity versus time, i.e. I-t, or instantaneous power) depending on the physicochemical parameter or the contact. The peak duration, amplitude, polarity and shape become a transducing signal for the properties of the contact event.

6- The condition for the active dimension of the invention in the micrometer to subcentimeter scale allows for the accommodation of such dimensions to respond to events with predetermined ranges of contact areas.

7- Providing the first self-powered touch device based on a triboelectric architecture that can be fabricated with micrometer to subcentimeter dimensions using standard CMOS, soft-lithography, printing or laser patterning technologies. Production of a highly integrated array of inventions using IC, CMOS, MEMS CCD technology, soft-lithography, printing, shadow masking, laser patterning, roll-to-roll processing, or other high-yield manufacturing techniques. The integrated array can be made in combination with organic, polymeric, inorganic, hybrid, flexible, and transparent triboelectric elements. The array can be made including a single triboelectric element or integrating different composition/functionalization triboelectric elements.

8- The integrated array can be formed by arrays of transductors with different sizes and shapes and connected to different capacitors or resistive loads or circuit elements in order to provide further physicochemical information about the contact event.

9- The array can be designed to provide information on different contacts at the same time (to obtain average values or individual values of the same property) or to provide different physicochemical information from the same contact event.

10- The integrated array arrangement can be used for detecting a single or multiple contact, e.g. detecting several fingers at the same time or the order of contact. These arrays can also be used to detect sliding, rotation, and intermittent contact. For example, it can be used to detect the movement for zoom in or zoom out or repetitive patterns. The integrated arrays can be also used to detect the shape of the object (finger) making the contact and with high accuracy the position of the contact.

11- Providing a detection procedure that can be based on the comparison of the tactile signal of a finger on two or more sensing elements with triboelectric elements with different functionalizations.

**DESCRIPTION OF THE DRAWINGS**

To complement the description being made and in order to aid towards a better understanding of the characteristics of the invention, in accordance with a preferred example of practical embodiment thereof, a set of drawings is attached as an integral part of said description wherein, with illustrative and non-limiting character, the following has been represented:

Figure 1.- Shows a schematic view of a first preferred embodiment of the triboelectric transductor device of the invention comprising a substrate.

Figure 2.- Shows two schematic views of a first preferred embodiment of the triboelectric transductor device of the invention comprising a substrate for different relative positions of the top electrode with respect to the bottom electrode. Figure 2A for the top electrode centered with respect to the bottom electrode. Figure 2B for the top electrode in a non-centered position with respect to the bottom electrode.

Figure 3.- Shows two schematic views of a first preferred embodiment of the triboelectric transductor device of the invention comprising a bifurcated top electrode. Figure 3A shows the lateral view. Figure 3B shows the top view.

Figure 4.- Shows two schematic views of a first preferred embodiment of the triboelectric transductor device of the invention comprising multiple top electrodes electrically connected. Figure 4A shows the lateral view. Figure 4B shows the top view.

Figure 5.- Shows a schematic view of a second preferred embodiment of the triboelectric transductor device of the invention comprising an extended triboelectric surface and an extended substrate.

Figure 6.- Shows schematic views of the first preferred (Figure 6A) and a second preferred embodiment (Figure 6B) of the triboelectric transductor device of the invention with a finger over the devices.

Figure 7.- Shows a schematic view of a third preferred embodiment of the device of the invention comprising a plurality of triboelectric transductors.

Figure 8.- Shows a schematic view of an array of triboelectric transductors, particularly, it shows the plurality of triboelectric transductors with bifurcated top electrode as an ordered array.

Figure 9.- Shows a schematic view of an array of triboelectric transductors, particularly, it shows the plurality of triboelectric transductors with bifurcated top electrode with different sizes or shapes forming an irregular distribution.

Figure 10.- Shows a schematic view of the third preferred embodiment of the invention where each finger being over a number of triboelectric transductors.

Figure 11.- Shows a schematic view of the third preferred embodiment of the triboelectric transductors having shared electrodes and/or substrates and/or triboelectric surface.

Figure 12.- Shows a graph showing the peak output voltage (Vout) produced by the triboelectric transductor device of the invention after touching - release with a dry finger for a resistive load RL = 10.0 MOhm and for a non-previously charged triboelectric element.

Figure 13.- Shows a graph showing the peaks output voltage (Vout) produced by the triboelectric transductor device of the invention by three cycles of touching - release with a dry finger for a resistive load RL = 10.0 MOhm and for a non-previously charged triboelectric element.

Figure 14.- Shows a graph showing the peaks output voltage (Vout) produced by the triboelectric transductor device of the invention after several cycles of touching - release with a dry finger for different resistive loads RL = 9.0 MOhm, RL = 8.9 MOhm, RL = 8.8 MOhm, and for a non-previously charged triboelectric element.

Figure 15.- Shows a graph showing the characteristic Vout - time peaks produced by the triboelectric element using different types of touch: wet finger, dry finger, nitrile glove, latex glove, for a resistive load RL = 10.0 MOhm and for a non-previously charged triboelectric element.

Figure 16.- Shows a graph comparing the peak output voltage (Vout) produced by the triboelectric transductor device of the invention after touching - release with a wet finger for a resistive load RL = 10.0 MOhm for a previously charged and a non-charged triboelectric elements. The device was previously charged using an electron beam.

Figure 17.- Shows a graph showing the zoom-in of the peak output voltage (Vout) produced by the triboelectric transductor device of the invention after touching with a wet finger for a resistive load RL = 10.0 MOhm and for a previously charged triboelectric element. The device was previously charged using an electron beam.

Figure 18.- Shows a graph comparing the peak output voltage (Vout) produced by the triboelectric transductor device of the invention after touching - release with a nitrile glove for a resistive load RL = 10.0 MOhm for a previously charged and a non-charged triboelectric elements.

## PREFERRED EMBODIMENTS OF THE INVENTION

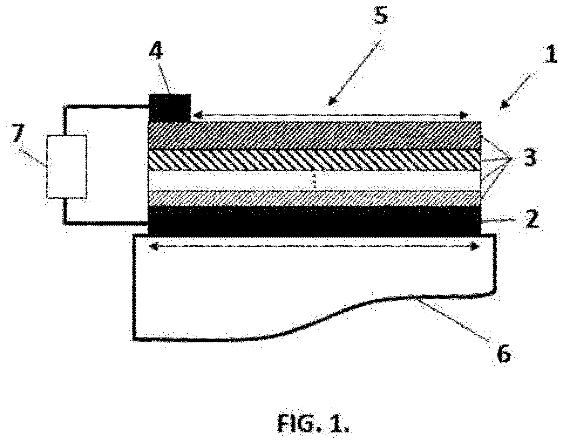

It is described below, with the help of figures 1 to 18, a preferred first embodiment of the self-powered triboelectric touch transductor device, object of the present invention.

A first preferred embodiment of the invention is depicted in Figure 1, showing a device comprising a single triboelectric transductor (1) and a signal acquisition and processing module (7), which can comprise at least a resistive load. The combination of both, the triboelectric transductor (1) and the acquisition and processing module (7) work as a touch sensor. The transductor (1) comprises in turn, at least an exposed top electrode (4) electrically connected and a bottom electrode (2) through at least a resistive load having dimensions ranging from micrometers to subcentimeter. Top and bottom electrodes (2, 4) can vary in composition, shape, length, thickness and distance to detect different touching events.

The bottom electrode (2), in this case, is placed on a substrate (6) over a certain area. On the bottom electrode (2), between it and the top electrode (4) a triboelectric friction element (3), which can comprise one or more layers, is disposed. The top electrode (4) is displayed leaving a gap (5) of non-overlapping area with the bottom electrode (2), which is intended to allow the finger to contact the triboelectric friction element (3). The top electrode (4) is placed over the triboelectric friction element (3), with a certain area always smaller than the bottom electrode (2) area and smaller than the contact area of the finger (or other solid) with the triboelectric friction element (3).

The triboelectric friction element (3) is charged negatively or positively. This charge can be generated either by natural sources such as constant friction, repeated contact events, wind, humidity or with the help of charge injection techniques.

Regarding the materials, the triboelectric friction element (3) can be organic, inorganic or hybrid, thin films, foils or plates. With respect to conductivity, the triboelectric friction element (3) can be a dielectric, insulator or semiconductor.

Dimension of each layer of the triboelectric friction element (3) such as width and length and area can arrange from micrometer to subcentimeter scale. The thickness of each layer of the triboelectric friction element (3) can arrange from nanometer to millimeter scale.

Electrodes (2, 4) can be organic, inorganic, hybrid, semiconducting or metallic. Preferably, the electrodes (2, 4) are manufactured from conductive materials that can be metal films or transparent systems such as transparent conducting oxides or alternative conducting materials as conducting polymers, graphene metal meshes, wires or nanowires and other materials formulations that comply with the electrical and optical requirements.

The invention can be manufactured as a self-standing transductor (1), or can be manufactured on any kind of support, such as flexible and non-flat substrates (6), as shown in Figure 1.

The triboelectric friction element (3) can be charged and can have a determined functionality as in the case of self-cleanable, omniphobic/philic, anti-bacterial, anti-microbial, anti-fouling and photoactive surfaces.

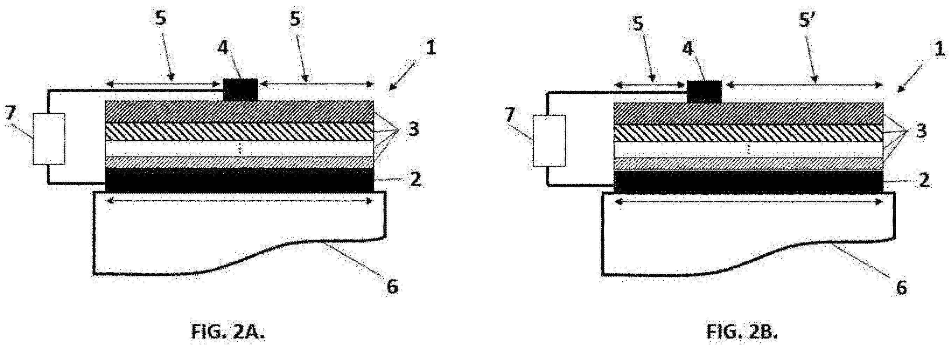

The invention can be manufactured with a single top electrode (4) emplaced at different positions with respect to the bottom electrode (2) as shown in Figure 2. The position of the top electrode (4) being overlapping with bottom electrode (2) and leaving symmetrical or asymmetrical gaps (5, 5').

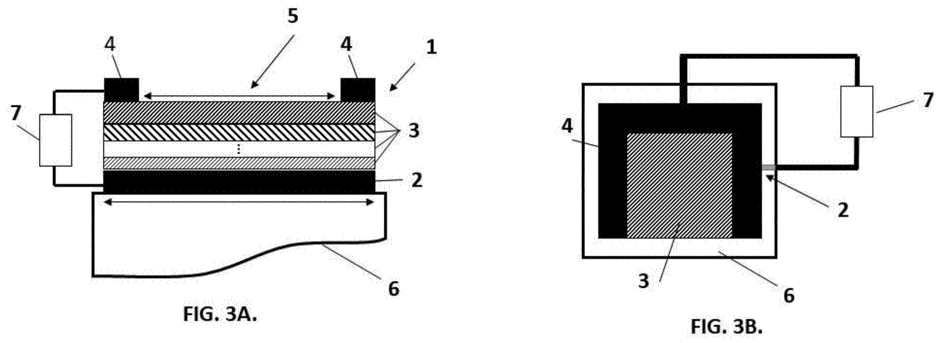

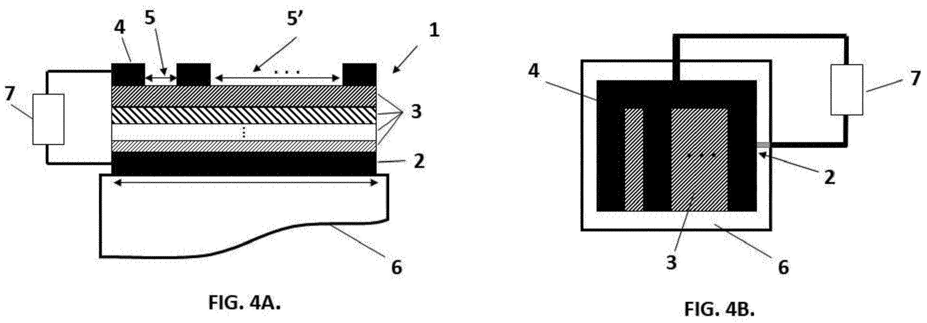

The invention can be manufactured with the top electrode (4) formed by a bifurcated top electrode as it is shown in Figure 3 or formed by several electrically connected lines or an electrical grid as it is shown in Figure 4.

In an aspect of the invention, the device additionally comprises a signal acquisition and processing module (7), connected to the transductor (1), and configured to analyse the shape, components, amplitude, polarity, duration and type of the electrical signal. In this case, the distribution of the transductors (1) can be designed to answer to the different parameters since the electrical signal generated by the invention can be used as sensing signal. The module (7) can incorporate artificial intelligence technology to elucidate the physicochemical parameters of complex contact events.

In this way, the device analyses the shape, components, time scale, amplitude, polarity and type of electrical signal (voltage and/or current and/or power) generated by the contact of the finger with the top electrode (4) and the triboelectric friction element (3). Also, the surface of the triboelectric friction element (3) can be further functionalized or modified (physically or chemically) to allow for a specific response to one of several analytes present in the finger.

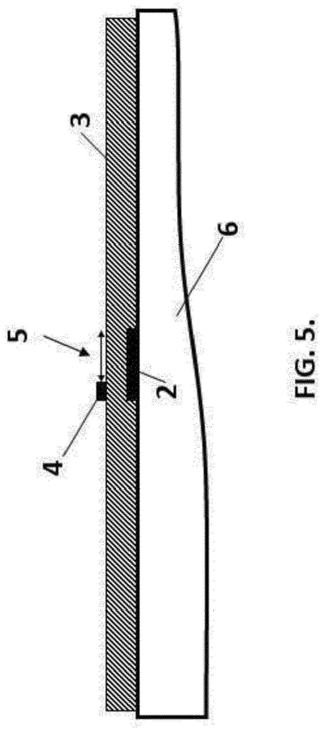

In a second embodiment of the invention, the bottom electrode (2) can be emplaced over an extended substrate (6) and the top electrode (4) over an extended triboelectric friction element (3), leaving a gap (5) of non-overlapping area on the triboelectric friction element (3) as shown in Figure 5. In this embodiment of the invention, the substrate (6) and triboelectric friction element (3) can be extended to areas larger than centimetre scale.

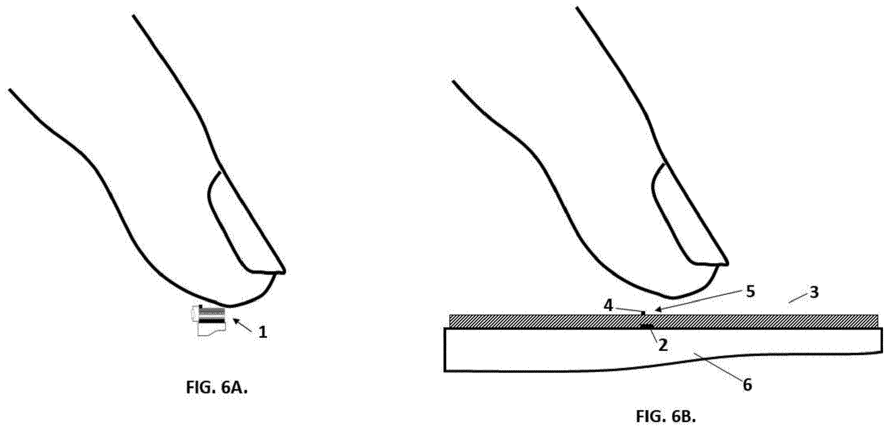

In the first and the second embodiments of the invention, the bottom and top electrodes (2, 4) and gap (5) area are intended to be in the micrometer to subcentimeter ranges, being said that the gap (5) defined in the invention is intended to be smaller than the finger contact area as it is schematized in Figure 6.

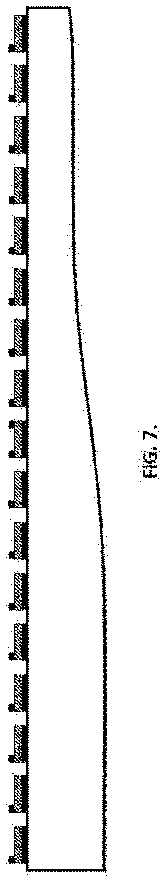

In another aspect of the invention, a set of transductors (1) are arranged to form an array of transductors as shown in Figure 7.

The transductors (1) in the array can incorporate different surface functionalization to respond to different physicochemical properties of the liquid. Each transductor (1) can be connected to a different acquisition and processing module (7) or the module (7) can be shared among several transductors (1).

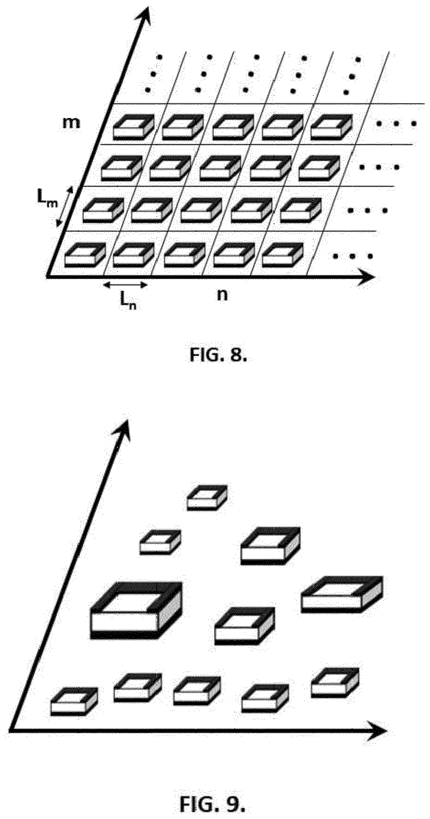

The array can be formed for a regular or an irregular distribution as shown in Figures 8 and 9.

The dimensions of the transductor (1) do not have to be the same for all of them and they can vary based on design requirements. The emplacement of the transductors (1) does not have to be regular or homogeneous and it can vary based on design requirements.

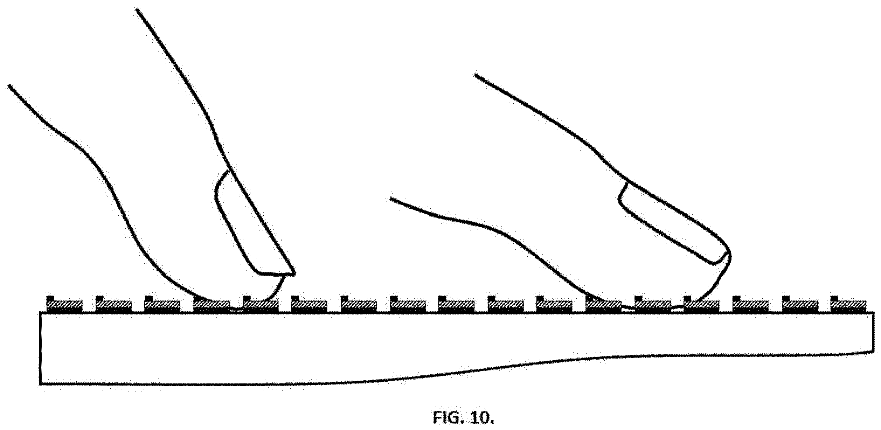

In another aspect of the invention, the array transductors (1) can analyse multiple contact events at the same time. As shown in Figure 10, the array of transductors (1) can be manufactured using CMOS, MEMS, IC, soft-lithography, printing and laser patterning technologies in micrometer and subcentrimeter scale to produce a large number of inventions in a very small area.

In Figure 10, every finger will make contact with several transductors (1) at the same time to produce the electric signal. This requires scaling down the dimensions of the sensors (1) to micrometer to subcentimeter range.

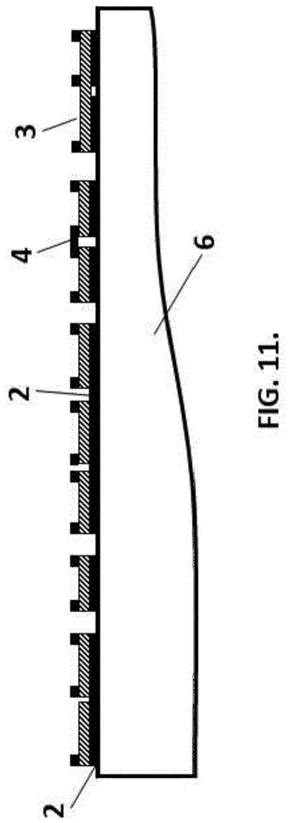

As depicted in Figure 11, several transductors (1) could share the substrate (6) or share a top electrode (4) or the triboelectric friction layer (3).

Configuring the transductor (1) in micrometer to subcentimeter scales as an array or following an irregular distribution provides advantages on the performance of the output signal:

- A finger can make contact with several transductors (1) at the same time and produce larger output signal with information on the contact event.
- A finger can make contact with several transductors (1) at the same time each of them with a different shape or different surface functionalization to provide information on the physicochemical parameters of the contact event.
- A finger can make contact with different transductors (1) after sliding or separating of the surface and produce a larger output signal with information on the finger movement, direction and velocity.
- A finger can make contact with different transductors (1) with different surface functionalization and provide information on the chemical analytes present in the finger.
- The different transductors (1) in the array can be connected to different resistive loads or impedance circuits or circuit elements or peak analysis modules (7) in order to increase the information that can be extracted from the generated electric signals.
- Several fingers can make contact with different transductors (1) and produce information. The average value of all the signals containing such information can be extracted.
- Several fingers can make contact with different transductors (1) and produce information. The particular signal containing such information can be extracted.
- The integrated array arrangement can be used for detecting a single or multiple contact, e.g. detecting several fingers at the same time or the order of contact. These arrays can also be used to detect sliding, rotation, and intermittent contact. For example, it can be used to detect the movement for zoom in or zoom out or repetitive patterns. The integrated arrays can be also used to detect the shape of the object (which finger is used) making the contact and with high accuracy the position of the contact.

The invention is fully compatible with the fabrication relying on transparent materials. The invention is also fully compatible with the fabrication based on rigid or flexible materials on flexible supports, improving the compatibility with wearable concepts for health monitoring, as well as with vibration and mechanical deformation self-powered sensors.

In an example of the second embodiment of the invention, the triboelectric friction element (3) is produced with a triboelectric film of PFA with an active area of 0.81 mm$^2$. Electrodes (2, 4) are fabricated through a shadow mask by physical vapor deposition of a transparent conducting oxide (ITO). In this specific embodiment, the voltage curves acquired as monitoring signals present the form of a positive peak with an asymmetrical shape followed by an asymmetrical negative peak. The amplitude, duration and shape of the peak depend on the physicochemical parameters of the contact (sweat, glove, frequency, contact area, etc). In this example, the top electrode (4) is displayed as a bifurcated electrode. In this example, the top and the bottom electrodes (2, 4) are connected through a resistive load ($R_L$).

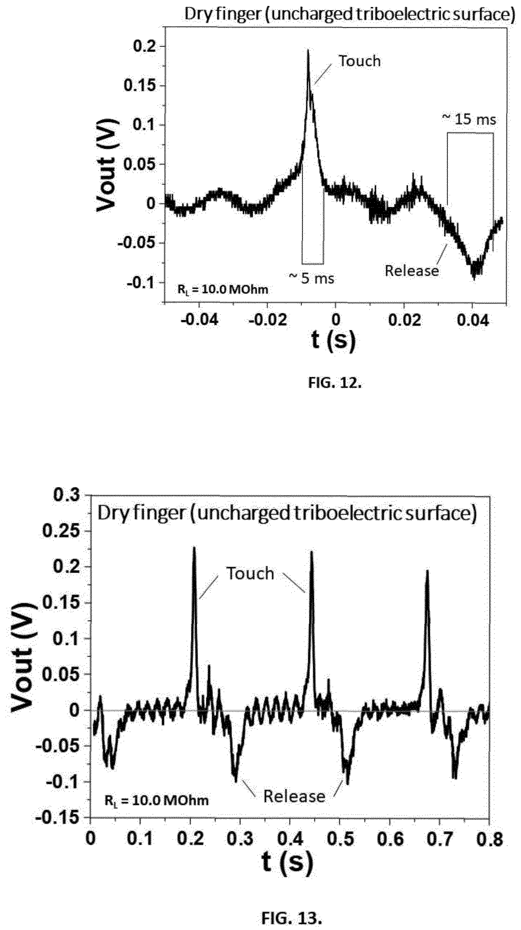

Figure 12 shows the characteristic output voltage of the invention in response to a touching - release event making contact with the top electrode (4) and the triboelectric friction element (3). The touching produces a positive peak of higher amplitude and shorter duration (a few milliseconds) than the release, being said that the release produces a negative peak. Therefore, the invention is capable of distinguishing between contact and release and is capable of responding in the millisecond range when is not previously charged.

Figure 13 shows the characteristic output voltage of the invention in response to three cycles of touching-release events making contact with the top electrode (4) and the triboelectric element (3). The touching produces repetitive positive peaks of higher amplitude and shorter duration (a few milliseconds) than the release, being said that the release produces a negative peak. Therefore, the invention is capable of responding to high-frequency touching - release cycles.

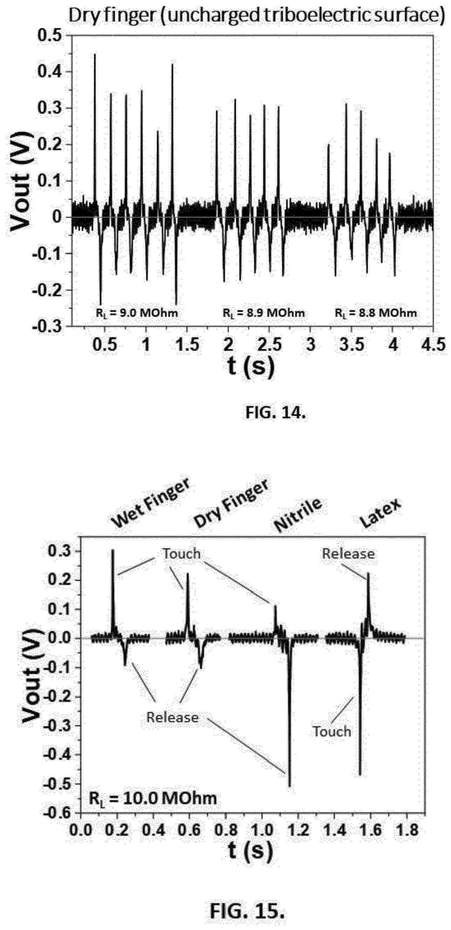

Figure 14 shows the characteristic output voltage of the invention in response to three cycles of touching-release events making contact with the top electrode (4) and the triboelectric friction element (3) for different resistive loads (7) emplaced between the top (4) and bottom (2) electrodes. The average amplitude of the peaks increases with the increase of the resistive loads. Therefore, the output of the invention can be enhanced by tuning and optimizing the acquisition module (7).

Figure 15 shows the characteristic output voltage of the invention in response to different chemical parameters of the finger making contact with the top electrode (4) and the triboelectric friction element (3). The fingers include a wet finger, dry finger, finger with a nitrile glove, and finger with a latex glove. Therefore, the invention is capable of distinguishing between the chemical nature of the solid making the contact. This is an indication of the application of the invention as a self-powered transductor device relying on the time response, peak amplitudes, and polarity switching.

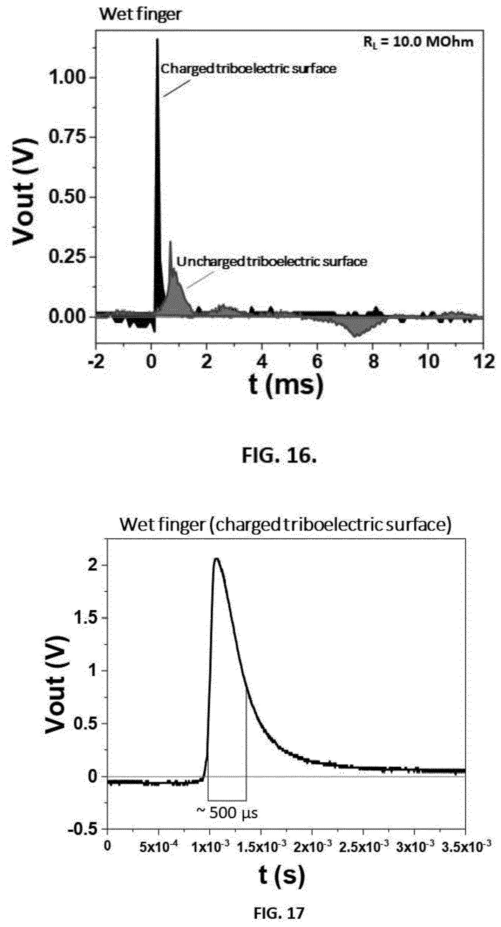

Figure 16 shows a graph gathering the peak output voltage ($V_{out}$) produced by the device of the invention for a wet finger comparing the response for a previously charged triboelectric friction element (3) with a non-charged triboelectric friction element. In this example, the triboelectric friction element (3) is negatively charged by an electron beam. This is an indication for the enhancement of the transductor (1) response by charging the triboelectric friction element (3) to obtain sharper peaks and higher amplitudes.

Figure 17 shows a zoom-in graph of the peak output voltage ($V_{out}$) produced by the device of the invention for a wet finger for a previously charged triboelectric friction element (3). In this example, the triboelectric friction element (3) is negatively charged by an electron beam. This is an indication of the sensor response by charging the triboelectric friction element (3) below the few millisecond threshold.

Thus, the architecture of the triboelectric transductor device and the reduced scale with respect to the contact area with a finger allows the sensing signal generation in a few milliseconds while the additional charging of the device by natural or artificial ways reduces the signal duration to microseconds. Being said that although in this example of the invention, the triboelectric friction element (3) has been charged by an electron beam, the surface charge of the triboelectric friction element (3) can be also produced under repeatedly touching with the finger or any other solid.

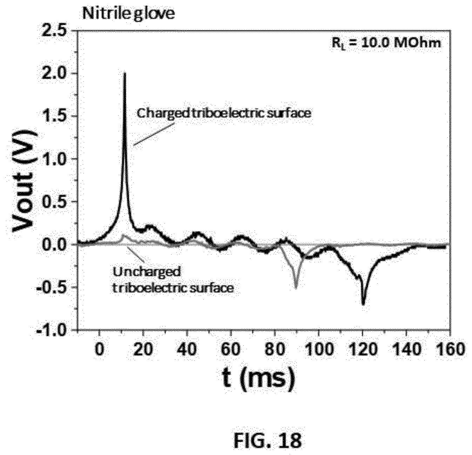

Figure 18 shows a graph gathering the peak output voltage ($V_{out}$) produced by the device of the invention for a finger covered by a nitrile glove comparing the response for a previously charged triboelectric element (3) with a non-charged triboelectric friction element (3). In this example, the triboelectric friction element (3) is negatively charged by an electron beam. This is an indication for the enhancement of the transductor response by charging the triboelectric friction element (3) to obtain better defined and sharper peaks and higher amplitudes.

**Claims**

1.  A self-powered triboelectric touch contact transductor device, said device comprising one or more transductors (1), and being the device **characterized in that** each transductor (1) comprises:

    - a bottom electrode (2),
    - at least a triboelectric friction element (3) electrically charged, that comprises one or more layers on top of the bottom electrode (2), being the area of the triboelectric friction element (3) at least as large as the area of the bottom electrode (2) and,
    - one or more exposed top electrodes (4) electrically connected and placed on the triboelectric friction element (3) on a surface opposite to the bottom electrode (2), being the top electrodes (4) of a smaller area than the bottom electrode (2) and defining at least one gap (5) on the triboelectric friction element (3) of non-overlapping area with respect to the bottom electrode (2), exposing the triboelectric friction element (3) to an external environment so that, on contacting with a finger or solid element, the capacitance of the transductor (1) varies and an electrical signal is generated.

2.  The device of claim 1, wherein it further comprises a signal acquisition and processing module (7) connected to the top (4) and bottom (2) electrodes of the transductors (1) and configured to analyse the shape, components, amplitude, polarity, duration and type of the electrical signal.

3.  The device of anyone of claims 1 or 2, where the triboelectric friction element (3) covers an extended area larger than the bottom electrode (2).

4.  The device of any of the preceding claims, further comprising one or more substrates (6) placed under the transductors (1), in contact with the bottom electrode (2).

5.  The device of claim 4, wherein the substrates (6) are rigid, flexible or non-flat.

6.  The device of any of the preceding claims, wherein it comprises two or more transductors (1) forming a regular or irregular array.

7.  The device of claim 6, wherein it comprises two or more transductors (1) forming an array and wherein each transductor (1) comprises a substrate (6).

8.  The device of claim 6, wherein it comprises two or more transductors (1) forming an array and wherein the device comprises a substrate (6) common for all the transductors (1).

9.  The device of any of the preceding claims, wherein the size of each transductor (1) ranges in a micrometer to subcentimeter scale.

10. The device of any of the preceding claims, wherein the electrodes (2, 4) are made of a material selected between metal foils, thin metallic films, metal wires and nanowires, transparent conducting oxides and polymers and graphene or metal meshes.

11. The device of any of the preceding claims, wherein the electrodes (2, 4) have a shape selected between round, triangular and rectangular.

12. The device of any of the preceding claims, wherein the triboelectric friction element (3) is chemically functionalized to respond to a specific analyte or agent present in the finger or solid element.

13. The device of any of the preceding claims, wherein the triboelectric friction element (3) is an insulator, a dielectric or a semiconductor.

14. The device of any of the preceding claims, wherein the triboelectric friction element (3) and the electrodes (2, 4) are made of a transparent material.

15. The device of any of the preceding claims, wherein the triboelectric friction element (3) and the electrodes (2, 4) are self-cleanable, photoactive, omniphobic/philic, anti-bacterial, anti-microbial, and/or anti-fouling material.

**FIG. 1.**

FIG. 2B.

FIG. 2A.

FIG. 3B.

FIG. 3A.

FIG. 4B.

FIG. 4A.

FIG. 5.

FIG. 6B.

FIG. 6A.

FIG. 7.

FIG. 8.

FIG. 9.

FIG. 10.

**FIG. 11.**

**FIG. 12.**

**FIG. 13.**

FIG. 14.

FIG. 15.

FIG. 16.

FIG. 17

FIG. 18

Europäisches
Patentamt

European
Patent Office

Office européen
des brevets

# EUROPEAN SEARCH REPORT

Application Number

EP 23 38 2177

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 035 398 A1 (BEIJING INST NANOENERGY & NANOSYSTEMS [CN]) 22 June 2016 (2016-06-22) * paragraph [0040] - paragraph [0055]; figures 1-4 * | 1-15 | INV. G06F3/041 G06F3/044 H03K17/96 |
| A | WO 2018/002752 A1 (SABIC GLOBAL TECHNOLOGIES BV [NL]) 4 January 2018 (2018-01-04) * paragraph [0027] - paragraph [0037]; figures 1, 2A, 2B * | 1-15 | |
| A | XIANDI WANG ET AL: "Self-Powered High-Resolution and Pressure-Sensitive Triboelectric Sensor Matrix for Real-Time Tactile Mapping", ADVANCED MATERIALS, VCH PUBLISHERS, DE, vol. 28, no. 15, 16 February 2016 (2016-02-16), pages 2896-2903, XP071816665, ISSN: 0935-9648, DOI: 10.1002/ADMA.201503407 * the whole document * | 1-15 | |
| A | CN 207 148 588 U (UNIV SUZHOU) 27 March 2018 (2018-03-27) * abstract; figures * | 1-15 | TECHNICAL FIELDS SEARCHED (IPC) G06F H03K |

The present search report has been drawn up for all claims

| Place of search | Date of completion of the search | Examiner |
|---|---|---|
| Berlin | 12 July 2023 | Mouton, Benjamin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 38 2177

This annex lists the patent family members relating to the patent documents cited in the above-mentioned European search report.
The members are as contained in the European Patent Office EDP file on
The European Patent Office is in no way liable for these particulars which are merely given for the purpose of information.

12-07-2023

| Patent document cited in search report | | Publication date | Patent family member(s) | | Publication date |
|---|---|---|---|---|---|
| EP 3035398 | A1 | 22-06-2016 | CN | 103777803 A | 07-05-2014 |
| | | | EP | 3035398 A1 | 22-06-2016 |
| | | | JP | 6353535 B2 | 04-07-2018 |
| | | | JP | 2016535894 A | 17-11-2016 |
| | | | KR | 20160071367 A | 21-06-2016 |
| | | | KR | 20180053772 A | 23-05-2018 |
| | | | WO | 2015021761 A1 | 19-02-2015 |
| WO 2018002752 | A1 | 04-01-2018 | NONE | | |
| CN 207148588 | U | 27-03-2018 | NONE | | |

EPO FORM P0459

For more details about this annex : see Official Journal of the European Patent Office, No. 12/82

**EP 4 421 598 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 9921678 B2
- US 10042446 B2
- US 20210404844 A1
- US 20200183511 A1
- WO 2019171295 A2
- WO 2019155376 A
- EP 3783328 A1
- EP 3742143 A1
- EP 3617856 A1